Europäisches Patentamt

European Patent Office

Office européen des brevets

(19)

(11) Veröffentlichungsnummer: **0 004 326**
B1

(12) # EUROPÄISCHE PATENTSCHRIFT

(45) Veröffentlichungstag der Patentschrift:
29.09.82

(51) Int. Cl.³: **G 03 D 3/06**, G 03 F 7/02

(21) Anmeldenummer: **79100724.8**

(22) Anmeldetag: **12.03.79**

(54) Einrichtung zur Entwicklung von Druckplatten mit einem Behandlungsflüssigkeit aufnehmenden Tank.

(30) Priorität: **18.03.78 DE 7808341 U**

(43) Veröffentlichungstag der Anmeldung:
**03.10.79 Patentblatt 79/20**

(45) Bekanntmachung des Hinweises auf die Patenterteilung:
**29.09.82 Patentblatt 82/39**

(84) Benannte Vertragsstaaten:
**BE DE FR GB IT NL SE**

(56) Entgegenhaltungen:
**FR-A-1 235 234**
**US-A-3 418 913**
**US-A-3 698 454**
**US-A-3 729 256**

(73) Patentinhaber: **HOECHST AKTIENGESELLSCHAFT,
Postfach 80 03 20, D-6230 Frankfurt/Main 80 (DE)**

(72) Erfinder: **Salzburg, Wolfgang, Am Hochfeld,
D-6200 Wiesbaden (DE)**
Erfinder: **Krause, Dieter, Alemannenstrasse 12,
D-6200 Wiesbaden (DE)**
Erfinder: **Töpfer, Dieter, Mühlweg 5,
D-6209 Heidenrod 3 (DE)**

ACTORUM AG

## Einrichtung zur Entwicklung von Druckplatten mit einem Behandlungsflüssigkeit aufnehmenden Tank

Die Erfindung betrifft eine Einrichtung zur Entwicklung von Druckplatten mit wenigstens einem Behandlungsflüssigkeit aufnehmenden Tank und mindestens einem Filter, durch das die Behandlungsflüssigkeit in ihrem Strömungsweg von und/oder zu dem Tank geleitet wird, und das ohne separates Filtergehäuse innerhalb des Tanks angeordnet ist.

Aus der US-Patentschrift 3 418 913 ist eine derartige Entwicklungseinrichtung mit wenigstens einem Behandlungsflüssigkeit aufnehmenden Tank und mindestens einem Filter bekannt, in der Filmblätter mit einer lichtempfindlichen, auf einem Trägermaterial angebrachten Schicht mit einer oder mehreren Flüssigkeiten behandelt werden. Diese Einrichtung dient speziell zur Entwicklung von fotografischem Material in Form der Filmblätter, nicht jedoch zur Entwicklung von Druckplatten. Die Tanks in dieser Einrichtung sind nicht auf einem aus der Einrichtung herausziehbaren Schlitten angebracht.

In der US-Patentschrift 3 698 454 ist eine fotografische Entwicklungseinrichtung beschrieben, bei der zur leichteren Handhabung ein Tank, der die Behandlungsflüssigkeit enthält, auf einem aus der Einrichtung herausziehbaren Schlitten angebracht ist. Der den Tank abschliessende Deckel ist nicht ortsfest angeordnet und muss bei dem Herausziehen des Schlittens angehoben werden, wenn Behandlungsflüssigkeit in den Tank gefüllt werden soll. Da sich häufig auf dem Deckel Spuren der Behandlungsflüssigkeit im angetrockneten Zustand befinden, erfordert das Anfassen des Deckels eine nachfolgende Handreinigung für das Bedienungspersonal.

In den Einrichtungen zum Entwickeln von Druckplatten wird die Behandlungsflüssigkeit aus dem Tank mittels einer Umwälzpumpe gepumpt und beispielsweise einem Sprührohr zugeführt, das mit Bürsten und/oder Rakeln kombiniert sein kann, oder einer Wanne, durch welche die zu entwickelnde Druckplatte hindurchläuft. Im Strömungsweg vom Tank zu diesen Einrichtungen ist wenigstens ein Filter angeordnet, um Schmutzteilchen und losgelöste Schichtteile, die mit der Behandlungsflüssigkeit abgeschwemmt werden, von der zu entwickelnden Druckplatte fernzuhalten. Dieses Filter sitzt üblicherweise auf der Druckseite der Umwälzpumpe. Die Behandlungsflüssigkeit wird über eine Rücklaufleitung, in die ebenfalls ein Filter im allgemeinen eingeschaltet ist, in den Tank zurückgeführt. Als Behandlungsflüssigkeit kommt insbesondere flüssiger Entwickler, aber auch Flüssigkeit zum Nachbehandeln der entwickelten Druckplatte, beispielsweise zum Auftragen einer Schutzschicht, in Betracht.

Bei den bisher bekannten Einrichtungen zur Entwicklung von Druckplatten der eingangs genannten Gattung sind die Tanks und die Filter der Filteranlage in der Einrichtung ortsfest eingebaut. Ebenso sind weitere Aggregate, die dazu dienen, die Behandlungsflüssigkeit auf der gewünschten Temperatur und dem gewünschten Niveau in dem Tank zu halten, ebenso eine Umwälzpumpe zum Fördern der Behandlungsflüssigkeit aus dem Tank zu der Druckplattenbehandlungseinrichtung, fest in der Einrichtung angebracht.

Daraus ergibt sich das Problem, die innerhalb der Einrichtung schlecht zugänglichen Tanks in der gewünschten Weise zu warten, d.h. zu reinigen, zu überprüfen und zu füllen, damit immer ausreichende und einwandfreie Chemikalien in der Einrichtung zum Entwickeln der Druckplatten vorhanden sind. Dieses Problem stellt sich in besonderer Schärfe bei Einrichtungen, durch die die Druckplatten horizontal zur Entwicklung durchlaufen, da hier die Platzverhältnisse besonders kritisch sind. Im einzelnen sind bei einer bekannten Einrichtung die fest eingebauten Tanks von der Vorderseite der Gesamteinrichtung aus zu füllen und zu reinigen. Hierzu muss das Bedienungspersonal in gebückter Haltung unter einem fest montierten Einlauftisch bei relativ schlechten Lichtverhältnissen arbeiten. Zu der voranstehend genannten Problemstellung gehört insbesondere die Wartung der Filter. Es ist bei der bekannten Einrichtung, in der die Filter, insbesondere die Feinfilter, in je einem Filtergehäuse untergebracht sind, das ausserhalb der Tanks in den Zuleitungen zu den Druckplattenbehandlungseinrichtungen angeordnet ist, besonders umständlich, die von Zeit zu Zeit auszutauschenden Filterpatronen zu entnehmen. Vor der Entfernung der die Filterpatronen umschliessenden separaten Filtergehäuse muss nämlich zunächst die Behandlungsflüssigkeit aus dem Filter und meist zwangsläufig im Zusammenhang damit die Behandlungsflüssigkeit aus dem höher angeordneten Teil der Zuführungsleitung entfernt werden. Die dabei auslaufende Behandlungsflüssigkeit muss aufgefangen werden, wenn sie nicht in das Innere der Einrichtung bzw. auf den Boden fliessen soll.

Der vorliegenden Erfindung liegt die Aufgabe zugrunde, eine Einrichtung zur Entwicklung von Druckplatten mit einem Behandlungsflüssigkeit aufnehmenden Tank zu schaffen, die es ermöglicht, den Tank und das oder die Filter in einfacher, bequemer und doch gründlicher Weise zu warten, d.h. zu reinigen, zu überprüfen und zu füllen und dabei auch die Filterpatronen auszutauschen.

Diese Aufgabe wird erfindungsgemäss durch eine Einrichtung zur Entwicklung von Druckplatten der eingangs genannten Gattung dadurch gelöst, dass der Tank in an sich bekannter Weise auf einem aus der Einrichtung herausziehbaren Schlitten angebracht ist, dass ein den Tank verschliessender Deckel, durch den ein Schlauch hindurchgeführt ist, ortsfest in einer Führung der Einrichtung angebracht ist und dass Führungsmittel zur Führung des mit dem Schlitten verschiebbaren Tanks vorgesehen sind.

Mit der Erfindung können die erforderlichen Wartungsarbeiten besonders einfach, zeitsparend und gründlich durchgeführt werden, da der Tank und die in ihm angeordneten Filter durch Herausziehen des Schlittens praktisch vollständig freigelegt werden, so dass diese Teile von mehreren Seiten aus gut zugänglich werden. Nach Durchführung der Wartungsarbeiten wird der Schlitten zusammen mit den darauf angeordneten Aggregaten wieder in die Einrichtung eingeschoben. Der Wegfall eines separaten Filtergehäuses, welches die Filterpatronen einschliesst, spart Entwicklervolumen ein, da kein Filtergehäuse ein zusätzliches, Behandlungsflüssigkeit aufnehmendes Volumen bildet. Beim Wechsel der Filterpatronen kann der Innenraum der Einrichtung nicht verschmutzen, da sich das Filter innerhalb des Tanks befindet, der einen flüssigkeitsdichten Abschluss gegenüber der Umgebung sicherstellt. Es entfällt nicht nur das Filtergehäuse, sondern Befestigungselemente für das Filter an dem Gehäuse und die Abdichtung von Schlauchleitungen, die in das Filtergehäuse führen.

Beim Herausziehen des Tanks auf dem Schlitten aus der Einrichtung wird der Deckel in seiner Einbaulage festgehalten, wobei er in den Führungsmitteln gleitet, die oben an dem Tank angebracht sind. Beim Einschieben des Tanks auf dem Schlitten wird dadurch der Deckel zwangsläufig in seine ursprüngliche Stellung zurückgebracht, so dass er die Oberseite des Tanks abschliesst. Die Rücklaufleitung ist so angeordnet, dass sie auch in der herausgezogenen Stellung des Tanks innerhalb des Tankvolumens verbleibt. Dies bedeutet, dass in der eingeschobenen Stellung der Schlauch auf der vorderen Seite des Tanks – gesehen in Zugrichtung des Schlittens – angeordnet ist, während er sich im herausgezogenen Zustand des Tanks in der Anschlagstellung des Schlittens in Nähe des hinteren Abschlusses des Tanks befindet. Ebenso wie dieses Ende des Schlauches verbleibt ein gegebenenfalls an ihm angebrachtes Vorfilter in jeder Stellung des Tanks innerhalb des Tankvolumens. Das Innere des Tanks und die in ihm untergebrachten Filter sind nur durch Herausziehen des Schlittens aus der Einrichtung zugänglich, wobei eine gesonderte umständliche Handhabung des Deckels entfällt.

Eine besonders zweckmässige Ausführung der erfindungsgemässen Einrichtung weist das Merkmal auf, dass der Schlitten seitlich quer zur Transportrichtung der Druckplatten aus der Einrichtung herausziehbar ist.

Bei dieser Anordnung wird die Zugänglichkeit der herausgezogenen Tanks mit den darin angeordneten Filtern nicht durch einen Einlauftisch beeinträchtigt. Ausserdem können so mehrere Tanks unter den ihnen zugeordneten Druckplattenbehandlungseinrichtungen derart nebeneinander angeordnet werden, dass die Zuleitungen zu den Druckplattenbehandlungseinrichtungen möglichst kurz sind und dass die Tanks ohne gegenseitige Behinderungen aus der Einrichtung herausgezogen werden können.

Zum möglichst bequemen Ein- und Ausfahren des Schlittens mit den auf ihm angebrachten Bauelementen und Baugruppen ist der Schlitten zweckmässig auf Rollen gelagert.

Eine besonders vorteilhafte Ausgestaltung der Erfindung geht von einer bekannten Einrichtung der eingangs genannten Gattung mit einer Umwälzpumpe, mit der Behandlungsflüssigkeit aus dem Tank absaugbar und einer Druckplattenbehandlungseinrichtung zuführbar ist, und gegebenenfalls mit weiteren Einrichtungen zum Heizen, Kühlen und Niveauhalten der Behandlungsflüssigkeit in dem Tank aus. Die besonders zweckmässige Weiterbildung besteht darin, dass auf der vorderen Seite des Schlittens in Zugrichtung gesehen der Tank angebracht ist, dass dahinter auf dem Schlitten die Umwälzpumpe und gegebenenfalls die weiteren Einrichtungen zum Heizen, Kühlen und Niveauhalten angeordnet sind, dass mindestens ein Anschlag in der Bewegungsbahn des Schlittens vorgesehen ist, an dem der Schlitten anstösst, wenn er in einer Anschlagstellung zur Freigabe des Tanks aus der Einrichtung herausgezogen ist, und dass der Anschlag zum vollständigen Herausziehen aus der Einrichtung durch Lösen einer Verriegelung beseitigbar ausgebildet ist.

Bei dieser Einrichtung ist also auf dem herausziehbaren Schlitten nicht nur der Tank angebracht, sondern es befinden sich auf diesem Schlitten auch weitere Aggregate, die, wenn auch in grösseren Intervallen, im Bedarfsfall ebenfalls gut zugänglich sein sollen. Normalerweise kann zur Wartung des Tanks sowie der in ihm angeordneten Filter der Schlitten in eine erste Anschlagstellung aus der Einrichtung herausgezogen werden, in der der Anschlag wirksam ist. Diese Anschlagstellung ist ausreichend, um einer Bedienungsperson die bequeme und gründliche Wartung des Tanks und der Filter zu ermöglichen. Sollen hingegen weitergehende Arbeiten oder Reparaturen insbesondere an der Umwälzpumpe oder den Einrichtungen zum Heizen, Kühlen und Niveauhalten der Behandlungsflüssigkeit vorgenommen werden, welche Arbeiten zweckmässigerweise durch einen Kundendiensttechniker vorzunehmen sind, so ist vor diesen Arbeiten der Anschlag aus der Bewegungsbahn des Schlittens dadurch zu beseitigen, dass eine Verriegelung des Anschlags gelöst wird. Danach kann der Schlitten vollständig aus der Einrichtung herausgezogen werden, so dass auch die weiteren Aggregate wie eine Heizung, ein Magnetventil in einer Kühlwasserleitung, ein Schwimmerschalter zur Niveauüberwachung oder ein Thermostatfühler bequem zugänglich werden.

Die Einrichtung ist ferner zweckmässig derart ausgestaltet, dass als Filter ein Vorfilter und ein Feinfilter in dem Tank angeordnet sind und dass das Vorfilter unterhalb der Öffnung des durch den Deckel in den Tank hineinreichenden Schlauchs angeordnet ist.

Dabei ist also das Vorfilter in der Rücklaufleitung angeordnet, während sich die Feinfilter auf der Ansaugseite der Umwälzpumpe des Strömungswegs befinden.

Weiterhin besteht eine vorteilhafte erste Variante darin, dass als Feinfilter mindestens eine auf dem Boden des Tanks senkrecht stehende Filterpatrone oberhalb eines durch den Boden hindurchreichenden Ansaugstutzens angeordnet ist und dass die Filterpatrone gegenüber dem Boden mit einer Dichtung abgedichtet ist.

Diese Anordnung ermöglicht eine besonders bequeme Zugänglichkeit der Feinfilter in dem Fall, in dem die Höhe des Tanks zur senkrechten Unterbringung der Filterpatronen ausreicht. Die Befestigungselemente der Filterpatrone befinden sich dabei zweckmässig auf ihrer Oberseite.

In einer weiteren vorteilhaften Ausgestaltung der ersten Variante ist vorgesehen, dass über dem Oberteil der Filterpatrone eine abdichtende Kappe gestülpt ist.

Mit dieser Kappe wird erreicht, dass trotz des bei dem Betrieb der Einrichtung zur Entwicklung von Druckplatten abfallenden Niveaus der in dem Tank gespeicherten Flüssigkeit keine Luft durch die stehend angeordnete Filterpatrone angesaugt wird, solange die Kappe tiefer als das tiefste zulässige Niveau in dem Tank herabreicht.

Zur besonders gut zugänglichen und sicheren Befestigung der stehenden Filterpatrone in der ersten Variante ist das Merkmal vorgesehen, dass die Filterpatrone mit einem schwenkbaren Arretierungsblech befestigbar ist, welches um einen von dem Boden hochreichenden Stehbolzen schwenkbar ist und durch eine sich an dem Kopf des Stehbolzens abstützende Feder an die Oberseite der Filterpatrone pressbar ist.

Die zweckmässig paarweise nebeneinander angeordneten Filterpatronen werden also dadurch befestigt, dass das Arretierungsblech über sie geschwenkt wird, wobei das Arretierungsblech auf die Oberseite der Filterpatrone gepresst wird.

In einer zweiten Variante, die besonders dann vorteilhaft ist, wenn in den Tanks keine genügende Einbauhöhe zur Verfügung steht, ist vorgesehen, dass als Feinfilter mindestens eine Filterpatrone in der Nähe des Bodens horizontal angeordnet ist.

Zwei Ausführungsbeispiele der Neuerung werden im folgenden anhand einer Zeichnung mit vier Figuren erläutert.

Es zeigt:

Figl 1 eine erste Variante der Einrichtung mit innerhalb eines Tanks stehend angeordneten Filterpatronen, wobei der Tank in die Einrichtung zur Entwicklung von Druckplatten eingeschoben ist,

Fig. 2 einen Schnitt durch die Führung eines Deckels in Richtung AA' in Fig. 1,

Fig. 3 den Tank einer zweiten Variante der Einrichtung in einem Längsschnitt, in dem die Filterpatronen liegend angeordnet sind, und

Fig. 4 den Tank mit liegend angeordneten Filterpatronen in einer Draufsicht.

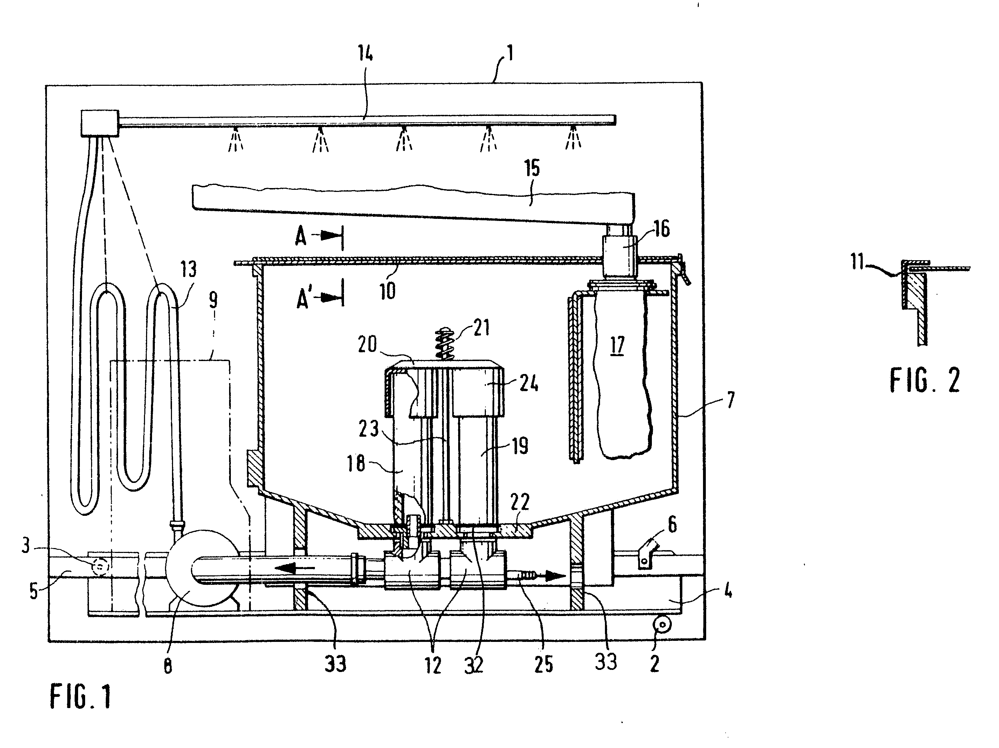

In Fig. 1 ist mit 1 das Gehäuse einer Einrichtung zur Entwicklung von Druckplatten bezeichnet. In dem Gehäuse ist ein auf Rollen 2, 3 gelagerter Schlitten 4 angeordnet. Beide Rollen laufen in Halbzeugprofilen, von denen das Halbzeugprofil 5 in der Zeichnung angedeutet ist.

Der Schlitten 4 ist aus dem Gehäuse 1 herausziehbar, bis die in dem Halbzeugprofil 5 laufende Rolle 3 gegen einen Anschlag 6 stösst. Zum noch weiteren Herausziehen des Schlittens aus dem Gehäuse muss der Anschlag durch Lösen einer nicht dargestellten Verriegelung aus der Bewegungsbahn der Rolle 3 beseitigt werden.

Auf dem Schlitten 4 sind ein Tank 7 in der Nähe der Vorderseite des Schlittens sowie eine Umwälzpumpe 8 und gegebenenfalls weitere Aggregate, die durch einen unterbrochen umrandeten Kasten 9 angedeutet sind, im Bereich der Rückseite des Schlittens fest angebracht. Als solche Aggregate können eine Heizung, ein Magnetventil für eine Kühlwasserleitung, ein Schwimmerschalter zur Niveauüberwachung oder ein Thermostatfühler vorgesehen sein.

Oberhalb des Tanks ist ein Deckel 10 fest angeordnet, dem gegenüber der Tank 7 verschiebbar gelagert ist, indem der Deckel 10 in eine Führung 11 (Fig. 2) hineinreicht. Der Tank 7 ist mittels Stützen 33 auf dem Boden des Schlittens 4 abgestützt.

Das Innere des Tanks 7 steht über einen doppelten Ansaugstutzen 12 mit der Ansaugseite der Umwälzpumpe 8 in Verbindung. Die Umwälzpumpe ist druckseitig über einen ausziehbaren Schlauch 13 mit einem Sprührohr 14 verbunden, das oberhalb einer geneigten Auffangwanne 15 angeordnet ist.

Mit der tiefsten Stelle der Auffangwanne steht ein Rückführschlauch 16 in Verbindung, der durch den Deckel 10 in das Innere des Tanks 7 hineinreicht. Die Öffnung des Rückführschlauchs ist durch ein Vorfilter 17 abgeschlossen, das als Grobfilter wirkt und aus einem Damenstrumpf bestehen kann.

Ferner sind innerhalb des Tanks 7 nebeneinander stehend zwei Filterpatronen 18, 19 angeordnet, derart, dass der Ansaugstutzen 12 in die Filterpatronen hineinreicht. Die Filterpatronen sind als Feinfilter ausgebildet. Sie sind mittels eines Arretierungsbleches 20 befestigt, welches die Filterpatronen unter dem Druck einer Feder 21 auf den Boden 22 des Tanks drückt. Die Druckkraft wird durch einen Stehbolzen 23 aufgenommen, der an dem Boden 22 befestigt ist und an seinem kopfseitigen Ende als Widerlager der Feder 21 dient. Die Filterpatronen 18, 19 sind gegenüber dem Boden 22 durch Dichtungen 32 abgedichtet, wobei hierfür auch eine einzige durchgehende Dichtung vorgesehen sein kann.

Ausserdem sitzt auf der Oberseite jeder Filterpatrone eine Kappe 24, so dass bei dem im Betrieb der Einrichtung fallenden Niveau der Behandlungsflüssigkeit keine Luft angesaugt wird, solange das Niveau nicht unterhalb der Kappe fällt.

In Fig. 1 ist noch ein Anschluss 25 für einen nicht dargestellten Entleerungshahn dargestellt, der zur Entfernung der Restflüssigkeit aus dem Tank vorgesehen ist.

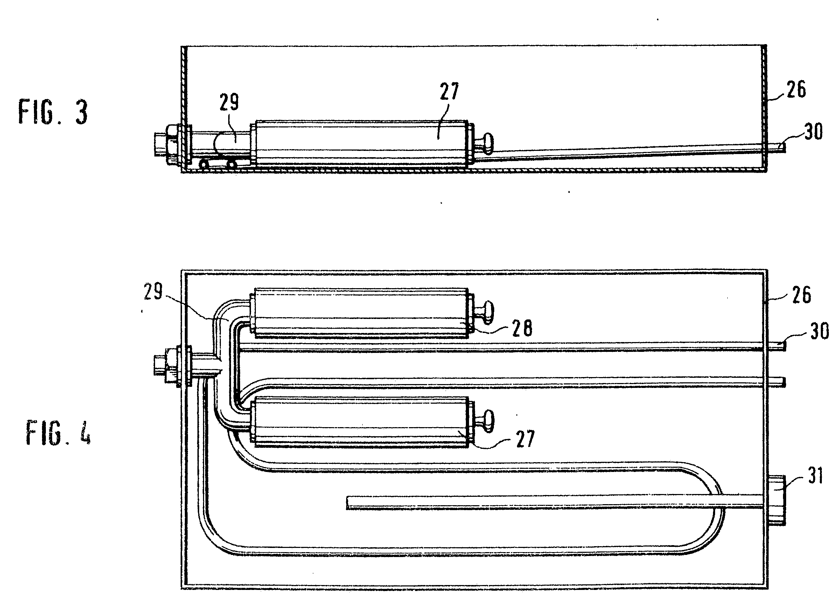

Aus den Fig. 3 und 4 ist eine zweite Variante der Einrichtung ersichtlich, bei der innerhalb des Tanks 26 Filterpatronen 27, 28 liegend angeordnet sind. Die Filterpatronen sind über ein Verzweigungsstück 29 an die Umwälzpumpe anschliessbar.

Aus den Fig. 3 und 4 ist ferner eine Leitung 30 ersichtlich, durch die ein Medium zum Heizen oder Kühlen der Behandlungsflüssigkeit fliessen kann. Schliesslich ist in Fig. 4 ein Thermostat 31 zum Einregeln der Temperatur der Behandlungsflüssigkeit dargestellt. Der Thermostat und die Leitung 30 wirken mit Aggregaten zum Heizen oder Kühlen zusammen, die an der Stelle des Kastens 9 in Fig. 1 untergebracht sind.

## Patentansprüche

1. Einrichtung zur Entwicklung von Druckplatten mit wenigstens einem Behandlungsflüssigkeit aufnehmenden Tank (7; 26) und mindestens einem Filter (17, 18, 19; 27, 28), durch das die Behandlungsflüssigkeit in ihrem Strömungsweg von und/oder zu dem Tank geleitet wird und das ohne separates Filtergehäuse innerhalb des Tanks angeordnet ist, dadurch gekennzeichnet, dass der Tank (7; 26) auf einem aus der Einrichtung herausziehbaren Schlitten (4) angebracht ist, dass ein den Tank (7; 26) verschliessender Deckel (10), durch den ein Schlauch (16) hindurchgeführt ist, ortsfest in einer Führung (11) des Tanks angebracht ist und dass Führungsmittel (2, 3, 5) zur Führung des Schlittens (4) vorgesehen sind.

2. Einrichtung nach Anspruch 1, dadurch gekennzeichnet, dass der Schlitten (4) seitlich, quer zur Transportrichtung der Druckplatten aus der Einrichtung herausziehbar ist.

3. Einrichtung nach den Ansprüchen 1 und 2, dadurch gekennzeichnet, dass der Schlitten (4) auf Rollen (2, 3) gelagert ist.

4. Einrichtung mit einer Umwälzpumpe, mit der die Behandlungsflüssigkeit aus dem Tank absaugbar und einer Druckplattenbehandlungseinrichtung zuführbar ist, und gegebenenfalls mit weiteren Einrichtungen zum Heizen, Kühlen und Niveauhalten der Behandlungsflüssigkeit in dem Tank gemäss Anspruch 1, dadurch gekennzeichnet, dass auf der vorderen Seite des Schlittens (4) in Zugrichtung gesehen der Tank (7) angebracht ist, dass dahinter auf dem Schlitten die Umwälzpumpe (8) und gegebenenfalls die weiteren Einrichtungen zum Heizen, Kühlen und Niveauhalten angeordnet sind, dass mindestens ein Anschlag (6) in der Bewegungsbahn des Schlittens vorgesehen ist, an dem der Schlitten anstösst, wenn er in einer Anschlagstellung zur Freigabe des Tanks aus der Einrichtung herausgezogen ist, und dass der Anschlag zum vollständigen Herausziehen des Schlittens aus der Einrichtung durch Lösen einer Verriegelung beseitigbar ausgebildet ist.

5. Einrichtung nach einem der Ansprüche 1 bis 4, dadurch gekennzeichnet, dass als Filter ein Vorfilter (17) und ein Feinfilter (18, 19) in dem Tank (7) angeordnet sind und dass das Vorfilter (17) unterhalb der Öffnung des durch den Deckel (10) in den Tank (7) hineinreichenden Schlauchs (16) angeordnet ist.

6. Einrichtung nach Anspruch 5, dadurch gekennzeichnet, dass als Feinfilter mindestens eine auf dem Boden des Tanks senkrecht stehende Filterpatrone (18, 19) oberhalb eines durch den Boden (22) hindurchreichenden Ansaugstutzens (12) angeordnet ist und dass die Filterpatrone (18, 19) gegenüber dem Boden mit einer Dichtung abgedichtet ist.

7. Einrichtung nach Anspruch 6, dadurch gekennzeichnet, dass über dem Oberteil der Filterpatrone eine abdichtende Kappe (24) gestülpt ist.

8. Einrichtung nach Anspruch 6 oder 7, dadurch gekennzeichnet, dass die Filterpatrone (18, 19) mit einem schwenkbaren Arretierungsblech (20) befestigbar ist, welches um einen von dem Boden hochreichenden Stehbolzen (23) schwenkbar ist und durch eine sich an dem Kopf des Stehbolzens (23) abstützende Feder (21) an die Oberseite der Filterpatrone (18, 19) pressbar ist.

9. Einrichtung nach Anspruch 5, dadurch gekennzeichnet, dass als Feinfilter mindestens eine Filterpatrone (27, 28) in der Nähe des Bodens horizontal angeordnet ist.

## Claims

1. Apparatus for developing printing plates, comprising at least one tank (7; 26) in which a processing liquid is contained and at least one filter (17, 18, 19; 27, 28), through which the processing liquid is passed on its flow path from and/or to the tank and which is arranged within the tank without a filter housing of its own, characterized in that the tank (7; 26) is mounted on a carriage (4) which can be withdrawn from the apparatus, and that a lid (10) which covers the tank (7; 26) and through which a tube (16) reaches into the tank is fixedly mounted in a guidance (11) of the tank, and that guide means (2, 3, 5) are provided to guide the carriage (4).

2. Apparatus according to claim 1, characterized in that the carriage (4) may be laterally withdrawn from the apparatus, transversely to the direction of transport of the printing plates.

3. Apparatus according to claims 1 and 2, characterized in that the carriage (4) is supported on rollers (2, 3).

4. Apparatus according to claim 1, comprising a circulating pump by means of which the processing liquid can be sucked from the tank and supplied to a printing plate processing station, and possibly further devices for heating and cooling the processing liquid and for maintaining its level in the tank, characterized in that the tank (7) is accomodated near the front end of the carriage (4), when seen in the direction in which it is withdrawn, and that the circulating pump (8) and possibly the further devices for heating and cooling the processing liquid and for maintaining its level are arranged behind the tank on the carriage, that at least one stop (6) is provided in the path of travel of the carriage against which carriage (4) abuts when it is withdrawn from the apparatus to a stop position in which the tank is accessible, and that the stop (6) is so designed that it can be removed by releasing a locking mechanism, so that the carriage can be completely withdrawn from the apparatus.

5. Apparatus according to any one of claims 1 to 4, characterized in that the filters arranged in the tank (7) are an antefilter (17) and at least one finemesh filter (18, 19), and that the antefilter (17) is positioned below the opening of the tube (16) which projects through the lid (10) into the tank (7).

6. Apparatus according to claim 5, characterized in that the fine-mesh filter is at least one upright filter cartridge (18, 19) which stands on the bottom of the tank (7) above an intake stack (12) passing through the bottom (22) and that the filter cartridge (18, 19) is sealed from the bottom by a packing.

7. Apparatus according to claim 6, characterized in that a sealing cap (24) is slipped over the top of the filter cartridge.

8. Apparatus according to claim 6 or 7, characterized in that the filter cartridge (18, 19) is fastened by a swivelling bracket (20) which can be swivelled about a stay bolt (23) attached to the bottom of the tank and is forced against the upper surface of the filter cartridge (18, 19) by a spring (21) which bears against the head of the stay bolt (23).

9. Apparatus according to claim 5, characterized in that the fine-mesh filter is at least one filter cartridge (27, 28) which is horizontally arranged near the bottom.


### Revendications

1. Installation pour le développement de plaques d'impression comportant au moins un réservoir (7; 26) pour la réception du liquide de traitement et au moins un filtre (17, 18, 19; 27, 28), à travers lequel on conduit le liquide de traitement venant du réservoir et/ou se dirigeant vers celui-ci et qui, sans être logé dans un compartiment séparé, est aménagé à l'intérieur du réservoir, caractérisé en ce que le réservoir (7; 26) est fixé sur un chariot (4) pouvant être tiré hors de l'installation, en ce que le couvercle (10) qui ferme le réservoir (7; 26) et donne passage à un tuyau souple (16) est maintenu fixement sur un dispositiv de guidage (11) du réservoir et en ce que des éléments de guidage (2, 3, 5) assurent le guidage du chariot (4).

2. Installation selon la revendication 1, caractérisé en ce que le chariot (4) peut être tiré hors de l'installation dans le sens transversal et perpendiculaire au sens de déplacement des plaques d'impression.

3. Installation selon les revendications 1 et 2, caractérisé en ce que le chariot (4) est monté sur des galets (2, 3).

4. Installation selon la revendication 1 équipée d'une pompe de circulation qui aspire le liquide de traitement contenu dans le réservoir pour le diriger sur une unité de traitement des plaques d'impression et, le cas échéant, un certain nombre d'équipements annexes assurant le chauffage, le refroidissement et la constance du niveau du liquide de traitement dans le réservoir caractérisée en ce que, vu en direction de la sortie du chariot (4) le réservoir (7) se trouve sur la partie avant de ce dernier, en ce que derrière ce réservoir (7) et sur le même chariot (4) se trouvent la pompe de circulation (8) et, le cas échéant, les autres équipements annexes assurant le chauffage, le refroidissement et la constance du niveau du liquide et en ce qu'une butée (6) au moins fixée dans la voie de coulissement du chariot (4) provoque l'arrêt de ce dernier lorsqu'il est tiré hors de l'installation afin de dégager le réservoir et en ce que la neutralisation d'un système de verrouillage permet d'annuler la butée (6) et de sortir le chariot entièrement de l'installation.

5. Installation selon l'une quelconque des revendications 1 à 4, caractérisée en ce que le groupe de filtrage comporte un préfiltre (17) et un filtre fin (18, 19) installés à l'intérieur du réservoir (7) et en ce que le préfiltre (17) est fixé au-dessous de l'ouverture pratiquée dans le couvercle (10) et offrant le passage au tuyau souple (16) pénétrant dans le réservoir (7).

6. Installation selon la revendication 5, caractérisée en ce qu'une cartouche à filtre (18, 19) au moins se trouve en tant que filtre fin, maintenu en position verticale sur le fond du réservoir (7) et placé au-dessus d'une tubulure d'aspiration (12) traversant le fond (22) et en ce que l'étanchéité de la cartouche à filtre (18, 19) par rapport au fond est assurée par un joint d'étanchéité approprié.

7. Installation selon la revendication 6, caractérisée en ce qu'une calotte étanche (24) coiffe la partie supérieure de la cartouche à filtre (18, 19).

8. Installation selon l'une quelconque des revendications 6 ou 7, caractérisée en ce que la cartouche à filtre (18, 19) est maintenue par une tôle de blocage (20) qui pivote autour d'une tige verticale (23) fixée sur le fond et qui, sous l'action d'un ressort (21) placé sur l'extrémité supérieure de cette tige verticale (23) est poussée contre l'extrémité supérieure de la cartouche à filtre (18, 19).

9. Installation selon la revendication 5, caractérisée en ce qu'une cartouche à filtre (27, 28) au moins se trouve en tant que filtre fin placée en position horizontale à proximité du fond du réservoir.

FIG. 1

FIG. 2

0 004 326

FIG. 3

29

27

26

30

FIG. 4

29

28

26

30

27

31

0 004 326